# EUROPEAN PATENT APPLICATION

(11) **EP 4 811 980 A1**
(43) Date of publication of application: **23.09.2026**
(21) Application number: 24890658.8
(22) Date of filing: 12.11.2024
(51) Int. Cl.: H10H 29/00

(54) **DISPLAY CHIP AND MANUFACTURING METHOD**

(30) Priority: 13.11.2023 CN 202311506815
(71) Applicant: Beijing Zitiao Network Technology Co., Ltd., Beijing 100190 (CN)
(72) Inventor: HUANG, Zhen, Beijing 100028 (CN); WANG, Chenggong, Beijing 100028 (CN); LI, Duo, Beijing 100028 (CN); LI, Xiaokai, Beijing 100028 (CN)
(74) Representative: Grünecker Patent- und Rechtsanwälte PartG mbB
(86) International application number: PCT/CN2024/131542
(87) International publication number: WO 2025/103303

(57) **Abstract**

The present application invention belongs to the technical field of semiconductors. Disclosed are a display chip and a manufacturing method. The display chip comprises: a chip structure, which comprises a first semiconductor layer, a quantum well light-emitting layer and a second semiconductor layer that are arranged in sequence, wherein one of the first semiconductor layer and the second semiconductor layer is an n-type semiconductor layer, and the other one is a p-type semiconductor layer, and the first semiconductor layer, the quantum well light-emitting layer and the second semiconductor layer are all nitrogen-polar film layers.

## Description

### CROSS-REFERENCE TO RELATED APPLICATIONS

The present application is based on and claims priority to Chinese Application No. 202311506815.2, filed on November 13, 2023, the disclosure of which is incorporated by reference herein in its entirety.

### TECHNICAL FIELD

The present application belongs to the technical field of semiconductors, and in particular, to a display chip and a manufacturing method.

### BACKGROUND

At present, a film material in a display device such as a micro light emitting diode (Micro-LED) is a gallium-polarity material. A growth temperature of a gallium-polarity film is relatively low, resulting in a relatively high threading dislocation density. Coupled with a quantum-confined Stark effect caused by a strong polarization electric field in a quantum well, the luminous efficiency of the display device is relatively low.

### SUMMARY

In a first aspect, the present application provides a display chip, including:
a chip structure, including a first semiconductor layer, a quantum well light emitting layer, and a second semiconductor layer that are arranged in sequence, where one of the first semiconductor layer and the second semiconductor layer is an n-type semiconductor layer, and the other one is a p-type semiconductor layer; and
where the first semiconductor layer, the quantum well light emitting layer, and the second semiconductor layer are all nitrogen-polarity film layers.

According to an embodiment of the present application, the chip structure further includes a fourth undoped semiconductor layer, a first barrier layer, a first superlattice layer, and a second superlattice layer that are arranged in sequence between the first semiconductor layer and the quantum well light emitting layer; and
the fourth undoped semiconductor layer, the first barrier layer, the first superlattice layer, and the second superlattice layer are all nitrogen-polarity film layers.

According to an embodiment of the present application, the fourth undoped semiconductor layer includes a u-GaN layer, and the first barrier layer includes a GaN layer; the first superlattice layer includes a u-InₐGa₁₋ₐN/u-GaN superlattice layer, 0.01≤a≤0.05; the second superlattice layer includes a u-In_{b}Ga_{1-b}N/n-GaN superlattice layer, 0.05≤b≤0.1.

According to an embodiment of the present application, the first semiconductor layer includes a heavily doped semiconductor layer and a lightly doped semiconductor layer located between the heavily doped semiconductor layer and the quantum well light emitting layer; and
the heavily doped semiconductor layer and the lightly doped semiconductor layer are both nitrogen-polarity film layers.

According to an embodiment of the present application, the heavily doped semiconductor layer includes an n-GaN heavily doped layer or an n-Al_{c}Ga_{1-c}N/n-GaN superlattice layer, 0.02≤c≤0.15; the lightly doped semiconductor layer includes an n-GaN lightly doped layer or an n-Al_{g}Ga_{1-g}N/n-GaN superlattice layer, 0.02≤g≤0.08.

According to an embodiment of the present application, the quantum well light emitting layer includes a fifth undoped semiconductor layer, a first well layer, a first cap layer, a second barrier layer, a sixth undoped semiconductor layer, a second well layer, a second cap layer, and a third barrier layer that are arranged in sequence between the first semiconductor layer and the second semiconductor layer; and
the fifth undoped semiconductor layer, the first well layer, the first cap layer, the second barrier layer, the sixth undoped semiconductor layer, the second well layer, the second cap layer, and the third barrier layer are all nitrogen-polarity film layers.

According to an embodiment of the present application, the fifth undoped semiconductor layer and the sixth undoped semiconductor layer each include a u-GaN layer, and the first cap layer and the second cap layer each include a GaN layer; the first well layer includes a u-InₓGa₁₋ₓN layer, 0.1≤x≤0.15; the second barrier layer includes a GaN layer or a u-In_{y}Ga_{1-y}N layer, 0.01≤y≤0.03; the second well layer includes a u-In_{z}Ga_{1-z}N layer, 0.35≤z≤0.4; the third barrier layer includes a u-Al_{d}Ga_{1-d}N layer, 0.3≤d≤0.35.

According to an embodiment of the present application, the second semiconductor layer includes an electron blocking layer, a hole injection layer, and an ohmic contact layer that are arranged in sequence on a side of the quantum well light emitting layer away from the first semiconductor layer; and
the electron blocking layer, the hole injection layer, and the ohmic contact layer are all nitrogen-polarity film layers.

According to an embodiment of the present application, the electron blocking layer includes a p-AlGaN polarization-induced layer or a p-AlₑGa₁₋ₑN/p-GaN superlattice layer, 0.15≤e≤0.25; the hole injection layer includes a p-GaN layer; the ohmic contact layer includes a p-In_{f}Ga_{1-f}N/p-GaN superlattice layer, 0.1≤f≤0.2.

According to an embodiment of the present application, the chip structure further includes a first transparent conductive layer, a first reflective layer, and a bonding layer that are sequentially located on a side of the second semiconductor layer away from the quantum well light emitting layer.

According to an embodiment of the present application, the chip structure further includes a protective layer located between the quantum well light emitting layer and the second semiconductor layer.

According to an embodiment of the present application, the quantum well light emitting layer includes a red light quantum well light emitting layer.

According to an embodiment of the present application, the display chip further includes a base plate; the base plate is bonded to a side of the chip structure away from the first semiconductor layer.

According to an embodiment of the present application, the display chip further includes a passivation layer and a second reflective layer; and
the passivation layer is located on a side of the chip structure away from the base plate and covers a side wall of the chip structure, and the second reflective layer covers the passivation layer.

According to an embodiment of the present application, the display chip further includes a second transparent conductive layer located on a side of the second reflective layer away from the base plate, and the second transparent conductive layer penetrates through the second reflective layer and the passivation layer and is connected to the first semiconductor layer.

According to an embodiment of the present application, the display chip further includes a third reflective layer located on a peripheral side of the chip structure, and a microlens located on a side of the second transparent conductive layer away from the chip structure.

In a second aspect, the present application provides a manufacturing method of a display chip, including:
forming a base;
forming a chip structure on one side of the base, the chip structure including a first semiconductor layer, a quantum well light emitting layer, and a second semiconductor layer that are arranged in sequence on the one side of the base, where one of the first semiconductor layer and the second semiconductor layer is an n-type semiconductor layer, and the other one is a p-type semiconductor layer, where the first semiconductor layer, the quantum well light emitting layer, and the second semiconductor layer are all nitrogen-polarity film layers; and
removing the base.

According to an embodiment of the present application, the base includes a substrate, a buffer layer, and an undoped semiconductor composite layer;
the forming the base includes:
providing the substrate;
forming the buffer layer on one side of the substrate; and
forming the undoped semiconductor composite layer on a side of the buffer layer away from the substrate, the chip structure being located on a side of the undoped semiconductor composite layer away from the buffer layer; and
where the buffer layer and the undoped semiconductor composite layer are both nitrogen-polarity film layers.

According to an embodiment of the present application, the undoped semiconductor composite layer includes a plurality of undoped semiconductor layers and at least one insertion layer that are arranged in a stacked manner, and there is one insertion layer between any two adjacent undoped semiconductor layers; and
the undoped semiconductor layers and the insertion layer are all nitrogen-polarity film layers.

According to an embodiment of the present application, the plurality of undoped semiconductor layers include a first undoped semiconductor layer, a second undoped semiconductor layer, and a third undoped semiconductor layer, and the at least one insertion layer includes a first insertion layer and a second insertion layer; the first undoped semiconductor layer, the first insertion layer, the second undoped semiconductor layer, the second insertion layer, and the third undoped semiconductor layer are arranged in sequence between the buffer layer and the first semiconductor layer; and
the first undoped semiconductor layer, the second undoped semiconductor layer, and the third undoped semiconductor layer each include a u-GaN layer, the first insertion layer includes a porous SiNₓ layer, and the second insertion layer includes an AlN layer.

According to an embodiment of the present application, the removing the base includes:
removing the substrate; and
removing the buffer layer and the undoped semiconductor composite layer.

According to an embodiment of the present application, before the removing the base, further including:
bonding a side of the chip structure away from the base to a base plate.

According to an embodiment of the present application, after the removing the base, further including:
forming a passivation layer on a side of the chip structure away from the base plate, and the passivation layer covers a side wall of the chip structure; and
forming a second reflective layer on a surface of the passivation layer.

According to an embodiment of the present application, the method further includes:
forming a second transparent conductive layer on a side of the second reflective layer away from the base plate, and the second transparent conductive layer penetrates through the second reflective layer and the passivation layer and is connected to the first semiconductor layer; and
forming a microlens on a side of the second transparent conductive layer away from the base plate.

Additional aspects and advantages of the present application will be set forth in part in the following description, and in part will be apparent from the following description, or may be learned by practice of the present application.

### BRIEF DESCRIPTION OF THE DRAWINGS

The above and/or additional aspects and advantages of the present application will become apparent and easy to understand from the description of the embodiments in conjunction with the following drawings, in which:
Fig. 1 is a schematic flowchart of a manufacturing method of a display chip provided by an embodiment of the present application;
Fig. 2 is a first structural schematic diagram in a manufacturing process of a display chip provided by an embodiment of the present application;
Fig. 3 is a second structural schematic diagram in a manufacturing process of a display chip provided by an embodiment of the present application;
Fig. 4 is a third structural schematic diagram in a manufacturing process of a display chip provided by an embodiment of the present application;
Fig. 5 is a fourth structural schematic diagram in a manufacturing process of a display chip provided by an embodiment of the present application;
Fig. 6 is a fifth structural schematic diagram in a manufacturing process of a display chip provided by an embodiment of the present application;
Fig. 7 is a sixth structural schematic diagram in a manufacturing process of a display chip provided by an embodiment of the present application;
Fig. 8 is a seventh structural schematic diagram in a manufacturing process of a display chip provided by an embodiment of the present application;
Fig. 9 is an eighth structural schematic diagram in a manufacturing process of a display chip provided by an embodiment of the present application;
Fig. 10 is a ninth structural schematic diagram in a manufacturing process of a display chip provided by an embodiment of the present application;
Fig. 11 is a tenth structural schematic diagram in a manufacturing process of a display chip provided by an embodiment of the present application;
Fig. 12 is an eleventh structural schematic diagram in a manufacturing process of a display chip provided by an embodiment of the present application;
Fig. 13 is a twelfth structural schematic diagram in a manufacturing process of a display chip provided by an embodiment of the present application;
Fig. 14 is a structural schematic diagram of a display chip provided by an embodiment of the present application.

### DETAILED DESCRIPTION

Embodiments of the present application will be described in detail below. Examples of the embodiments are shown in the drawings, and throughout the drawings, the same or similar reference numerals refer to the same or similar elements or elements having the same or similar functions. The embodiments described below with reference to the drawings are exemplary and are only used to explain the present application, and cannot be understood as a limitation to the present application.

A display chip and a manufacturing method thereof provided by embodiments of the present application are described below with reference to the drawings.

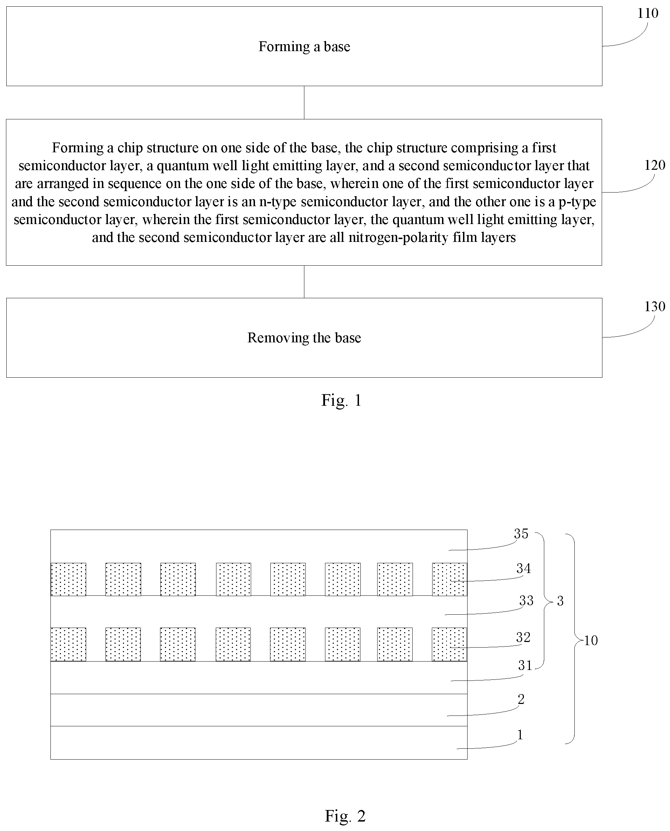

Fig. 1 is a schematic flowchart of a manufacturing method of a display chip provided by an embodiment of the present application. The display chip may be a Micro-LED display chip.

As shown in Fig. 1, the manufacturing method of the display chip provided by the embodiment of the present application includes step 110, step 120, and step 130.

Step 110: forming a base.

In some embodiments, as shown in Fig. 2, the base 10 may include a substrate 1, a buffer layer 2, and an undoped semiconductor composite layer 3. The forming the base in step 110 includes: providing the substrate 1; forming the buffer layer 2 on one side of the substrate 1; and forming the undoped semiconductor composite layer 3 on a side of the buffer layer 2 away from the substrate 1. The buffer layer 2 and the undoped semiconductor composite layer 3 are both nitrogen-polarity film layers.

The substrate 1 may include a sapphire substrate with a certain off-angle, etc. The buffer layer 2 may include an undoped GaN (u-GaN) layer, and a thickness of the buffer layer 2 may be 15 nm to 35 nm. The undoped semiconductor composite layer 3 may be a film layer with a low dislocation density.

For example, using an MOCVD (Metal-organic Chemical Vapor Deposition) system, a hydrogen atmosphere is first provided for the substrate 1 at a temperature of 1080 °C to 1100 °C for 300 s to 400 s. The hydrogen atmosphere is maintained, a reaction chamber temperature is reduced to 1020 °C to 1060 °C, and then ammonia gas is introduced to perform nitriding treatment on a surface of the substrate 1.

Then, the low-temperature buffer layer 2 is grown on one side of the substrate 1, that is, the hydrogen atmosphere is switched to a nitrogen atmosphere, ammonia gas continues to be introduced, and the reaction chamber temperature is reduced to 550 °C to 580 °C. The nitrogen atmosphere is maintained, the reaction chamber temperature is increased to 1060 °C to 1080 °C, and the buffer layer 2 is annealed for 500 s to 600 s.

It should be noted that the buffer layer 2 may also be formed by other processes, which is not specifically limited here.

The undoped semiconductor composite layer 3 is formed on the side of the buffer layer 2 away from the substrate 1. In some embodiments, the undoped semiconductor composite layer 3 includes a plurality of undoped semiconductor layers and at least one insertion layer that are arranged in a stacked manner, and there is one insertion layer between any two adjacent undoped semiconductor layers. The undoped semiconductor layers and the insertion layer are all nitrogen-polarity film layers. The insertion layer may reduce the threading dislocation density in the undoped semiconductor layer and improve the internal quantum efficiency of the chip.

In some embodiments, as shown in Fig. 2, the plurality of undoped semiconductor layers include a first undoped semiconductor layer 31, a second undoped semiconductor layer 33, and a third undoped semiconductor layer 35, and the at least one insertion layer includes a first insertion layer 32 and a second insertion layer 34. The first undoped semiconductor layer 31, the first insertion layer 32, the second undoped semiconductor layer 33, the second insertion layer 34, and the third undoped semiconductor layer 35 are arranged in sequence on the side of the buffer layer 2 away from the substrate 1.

The first undoped semiconductor layer 31 may include a u-GaN layer, and a thickness of the first undoped semiconductor layer 31 may be 300 nm to 500 nm. The first insertion layer 32 may include a porous SiNx layer. The first insertion layer 32 mainly functions to reduce, on the one hand, a defect density and an impurity ion concentration of the u-GaN layer, and on the other hand, a background electron concentration of the nitrogen-polarity u-GaN layer, so as to improve the mobility and the luminescence performance.

The second undoped semiconductor layer 33 may include a u-GaN layer, and a thickness of the second undoped semiconductor layer 33 is 1 µm to 1.2 µm. The second insertion layer 34 may include an AlN layer, and a thickness of the second insertion layer 34 may be 5 nm to 30 nm. The third undoped semiconductor layer 35 may include a u-GaN layer, and a thickness of the third undoped semiconductor layer 35 may be 1.5 µm to 2.5 µm. An overall thickness of the undoped semiconductor composite layer 3 may be 3 µm to 4 µm.

For example, after the buffer layer 2 is grown, the nitrogen atmosphere is switched to the hydrogen atmosphere, the reaction chamber temperature is increased to 1080 °C to 1100 °C, and the first undoped semiconductor layer 31 is grown on the side of the buffer layer 2 away from the substrate 1. Only ammonia (NH₃) and silane (SiH₄) are introduced, and the first insertion layer 32 is grown on the side of the first undoped semiconductor layer 31 away from the buffer layer 2.

Then, in the hydrogen atmosphere and at a reaction chamber temperature of 1080 °C to 1100 °C, the second undoped semiconductor layer 33 is grown on the side of the first insertion layer 32 away from the first undoped semiconductor layer 31. Then, the reaction chamber temperature is reduced to 900 °C to 1000 °C, and the low-temperature second insertion layer 34 is grown on the side of the second undoped semiconductor layer 33 away from the first insertion layer 32. Then, in the hydrogen atmosphere and at a reaction chamber temperature of 1080 °C to 1100 °C, the third undoped semiconductor layer 35 is grown on the side of the second insertion layer 34 away from the second undoped semiconductor layer 33.

It should be noted that the undoped semiconductor composite layer 3 may also be formed by other processes, which is not specifically limited here.

Step 120: forming a chip structure on one side of the base, the chip structure including a first semiconductor layer, a quantum well light emitting layer, and a second semiconductor layer that are arranged in sequence on the one side of the base, where one of the first semiconductor layer and the second semiconductor layer is an n-type semiconductor layer, and the other one is a p-type semiconductor layer, where the first semiconductor layer, the quantum well light emitting layer, and the second semiconductor layer are all nitrogen-polarity film layers.

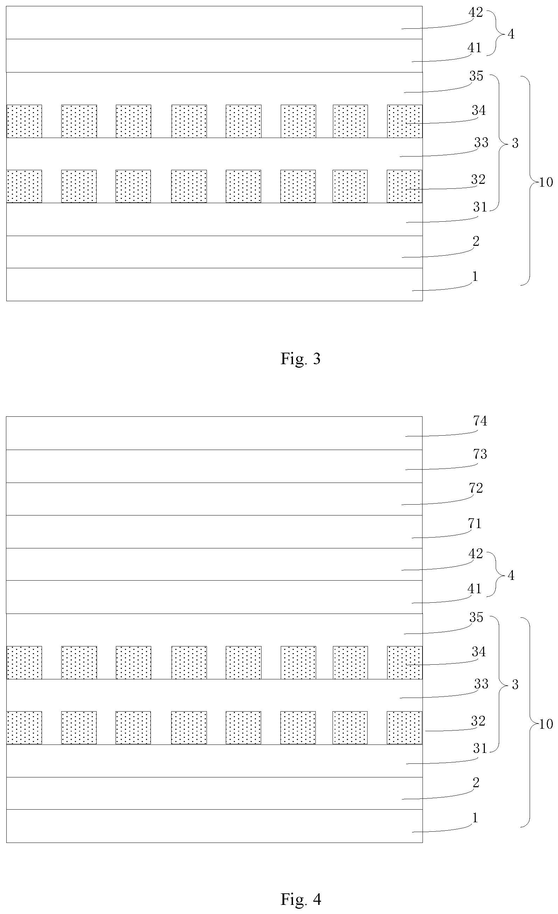

As shown in Figs. 3 to 7, the chip structure 20 includes the first semiconductor layer 4, the quantum well light emitting layer 5, and the second semiconductor layer 6. The forming the chip structure on the one side of the base in step 120 includes: forming the first semiconductor layer 4 on the one side of the base 10; forming the quantum well light emitting layer 5 on a side of the first semiconductor layer 4 away from the base 10; and forming the second semiconductor layer 6 on a side of the quantum well light emitting layer 5 away from the first semiconductor layer 4.

The first semiconductor layer 4 is an n-type semiconductor layer, and the second semiconductor layer 6 is a p-type semiconductor layer. Alternatively, the first semiconductor layer 4 is a p-type semiconductor layer, and the second semiconductor layer 6 is an n-type semiconductor layer. In some embodiments, the chip structure 20 is a nitrogen-polarity InGaN-based chip structure, the first semiconductor layer 4 is an n-type semiconductor layer, and the second semiconductor layer 6 is a p-type semiconductor layer.

In some embodiments, as shown in Fig. 3, the first semiconductor layer 4 includes the heavily doped semiconductor layer 41 and the lightly doped semiconductor layer 42. The heavily doped semiconductor layer 41 is located on one side of the base 10, for example, the heavily doped semiconductor layer 41 is located on a side of the undoped semiconductor composite layer 3 away from the substrate 1, and the lightly doped semiconductor layer 42 is located on a side of the heavily doped semiconductor layer 41 away from the base 10. The heavily doped semiconductor layer 41 and the lightly doped semiconductor layer 42 are both nitrogen-polarity film layers.

The heavily doped semiconductor layer 41 may include an n-GaN heavily doped layer, an electron concentration of the heavily doped semiconductor layer 41 is 1×10¹⁸cm⁻³ to 2×10¹⁹cm⁻³, and a thickness of the heavily doped semiconductor layer 41 is 0.5 µm to 1.5 µm.

For example, at a reaction chamber temperature of 1080 °C to 1100 °C, silane is introduced, and by using a δ doping method, a process of introducing silane is separated from a growth process of the heavily doped semiconductor layer 41 to periodically grow an undoped semiconductor layer. The n-type doping of the undoped semiconductor layer is realized by relying on the diffusion of Si atoms in the growth process, to obtain the heavily doped semiconductor layer 41. The undoped semiconductor layer may include a GaN layer, and the heavily doped semiconductor layer 41 may include an n-GaN layer. A periodic thickness of the undoped semiconductor layer may be 10 nm to 30 nm, and a flow rate of silane may be 2 nmol/min to 80 nmol/min, so that the electron concentration of the heavily doped semiconductor layer 41 may be 1×10¹⁸cm⁻³ to 2×10¹⁹cm⁻³, and the thickness of the heavily doped semiconductor layer 41 is 0.5 µm to 1.5 µm.

It should be noted that silane is usually selected as the n-type dopant for the GaN layer, but uniform silane doping leads to a decrease in the migration ability of Ga atoms, and V-shaped defects are easily formed. Therefore, the δ doping method is used in this embodiment to avoid the V-shaped defects.

The heavily doped semiconductor layer 41 may also include an n-Al_{c}Ga_{1-c}N/n-GaN superlattice layer, 0.02≤c≤0.15, and an electron concentration is 1×10¹⁸cm⁻³ to 2×10¹⁹cm⁻³. An Al component in n-Al_{c}Ga_{1-c}N is about 2% to 15%, a thickness may be 2 nm to 3 nm, and a thickness of n-GaN may be 2.5 nm to 15 nm. The n-Al_{c}Ga_{1-c}N/n-GaN superlattice layer may relieve the extension of dislocations and stress regulation.

The lightly doped semiconductor layer 42 may include an n-GaN lightly doped layer, an electron concentration of the lightly doped semiconductor layer 42 is 1×10¹⁷cm⁻³ to 5×10¹⁷cm⁻³, and a thickness of the lightly doped semiconductor layer 42 is 0.2 µm to 0.5 µm.

For example, at a reaction chamber temperature of 1080 °C to 1100 °C, silane is introduced, and by using the δ doping method, an undoped semiconductor layer is periodically grown, and the undoped semiconductor layer is doped with n-type ions to obtain the lightly doped semiconductor layer 42. The undoped semiconductor layer includes a GaN layer, and the lightly doped semiconductor layer 42 includes an n-GaN layer. The periodic thickness of the undoped semiconductor layer is 10 nm to 30 nm, and the flow rate of silane is 0.1 nmol/min to 1.5 nmol/min, so that the electron concentration of the lightly doped semiconductor layer 42 may be 1×10¹⁷cm⁻³ to 5×10¹⁷cm⁻³, and the thickness of the lightly doped semiconductor layer 42 is 0.2 µm to 0.5 µm.

The lightly doped semiconductor layer 42 may also include an n-Al_{g}Ga_{1-g}N/n-GaN superlattice layer, 0.02≤g≤0.08, and an electron concentration is 1×10¹⁷cm⁻³ to 5×10¹⁷cm⁻³. An Al component in n-Al_{g}Ga_{1-g}N is about 2% to 8%, a thickness is 2 nm to 3 nm, and a thickness of n-GaN is 2.5 nm to 15 nm.

In some embodiments, as shown in Fig. 4, the forming the chip structure in step 120 further includes: sequentially forming a fourth undoped semiconductor layer 71, a first barrier layer 72, a first superlattice layer 73, and a second superlattice layer 74 on the side of the first semiconductor layer 4 away from the base 10, the quantum well light emitting layer 5 being located on a side of the second superlattice layer 74 away from the first superlattice layer 73. The fourth undoped semiconductor layer 71, the first barrier layer 72, the first superlattice layer 73, and the second superlattice layer 74 are all nitrogen-polarity film layers.

The fourth undoped semiconductor layer 71 may include a u-GaN layer, and a thickness of the fourth undoped semiconductor layer 71 may be 10 nm to 30 nm. The first barrier layer 72 may include a GaN layer, and a thickness of the first barrier layer 72 may be 10 nm to 30 nm. The first superlattice layer 73 may include a u-InₐGa₁₋ₐN/u-GaN superlattice layer with at least one period (for example, 1 to 3 periods), 0.01≤a≤0.05. A thickness of u-InₐGa₁₋ₐN may be 2 nm to 3 nm, an In component is 1% to 5%, and a thickness of u-GaN may be 2.5 nm to 15 nm. The second superlattice layer 74 may include a u-In_{b}Ga_{1-b}N/n-GaN superlattice layer with at least one period (for example, 1 to 3 periods), 0.05≤b≤0.1. An electron concentration of n-GaN may be 1×10¹⁷cm⁻³ to 5×10¹⁷cm⁻³, a thickness of u-In_{b}Ga_{1-b}N may be 2 nm to 3 nm, an In component may be 5% to 10%, and a thickness of n-GaN may be 2.5 nm to 15 nm.

For example, after the lightly doped semiconductor layer 42 is grown, the reaction chamber temperature is reduced to 900 °C to 1000 °C, and the fourth undoped semiconductor layer 71 is grown on the side of the lightly doped semiconductor layer 42 away from the heavily doped semiconductor layer 41. The fourth undoped semiconductor layer 71 is used to repair hydrogen etching damage during the cooling process.

Then, the atmosphere is switched to the nitrogen atmosphere, the reaction chamber temperature is reduced to 800 °C to 900 °C, and the first barrier layer 72 is grown on the side of the fourth undoped semiconductor layer 71 away from the lightly doped semiconductor layer 42. Then, the first superlattice layer 73 is grown on the side of the first barrier layer 72 away from the fourth undoped semiconductor layer 71. The second superlattice layer 74 is continuously grown on the side of the first superlattice layer 73 away from the first barrier layer 72.

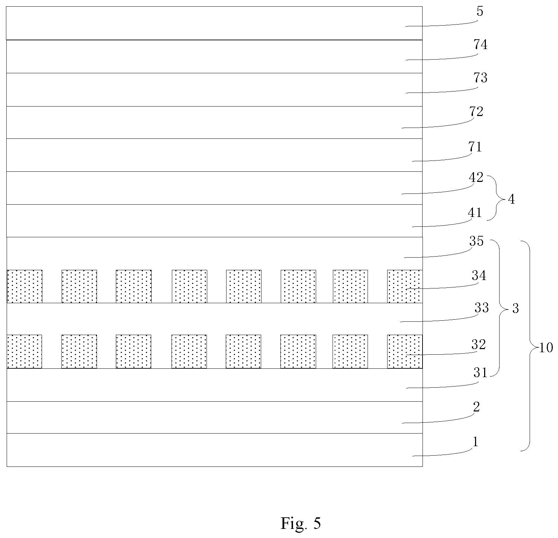

Then, as shown in Fig. 5, the quantum well light emitting layer 5 is formed on the side of the second superlattice layer 74 away from the first superlattice layer 73.

In some embodiments, the quantum well light emitting layer 5 includes a red light quantum well light emitting layer. In this embodiment, the nitrogen-polarity film layer is used, which may relieve the Droop effect of the chip under a large current injection and improve the red light efficiency.

In some embodiments, the quantum well light emitting layer 5 includes at least one periodic structure (for example, 2 to 3 periodic structures), each periodic structure including a fifth undoped semiconductor layer, a first well layer, a first cap layer, a second barrier layer, a sixth undoped semiconductor layer, a second well layer, a second cap layer, and a third barrier layer that are arranged in sequence between the first semiconductor layer 4 and the second semiconductor layer 6. The fifth undoped semiconductor layer, the first well layer, the first cap layer, the second barrier layer, the sixth undoped semiconductor layer, the second well layer, the second cap layer, and the third barrier layer are all nitrogen-polarity film layers.

The fifth undoped semiconductor layer may include a low-temperature u-GaN layer, and a thickness of the fifth undoped semiconductor layer may be 2 nm to 3 nm. The first well layer may include a u-InₓGa₁₋ₓN layer, 0.1≤x≤0.15, and a thickness of the first well layer may be 2.5 nm to 3.5 nm. The first cap layer may include a GaN layer, and a thickness of the first cap layer may be 2 nm to 3 nm. The second barrier layer may include a GaN layer or a u-In_{y}Ga_{1-y}N layer, 0.01≤y≤0.03, and a thickness of the second barrier layer may be 10 nm to 15 nm. The sixth undoped semiconductor layer may include a low-temperature u-GaN layer, and a thickness of the sixth undoped semiconductor layer may be 2 nm to 3 nm. The second well layer may include a u-In_{z}Ga_{1-z}N layer, 0.35≤z≤0.4, and a thickness of the second well layer may be 2.5 nm to 3.5 nm. The second cap layer may include a GaN layer, and a thickness of the second cap layer may be 2 nm to 3 nm. The third barrier layer may include a u-Al_{d}Ga_{1-d}N layer, 0.3≤d≤0.35, and a thickness of the third barrier layer may be 10 nm to 15 nm.

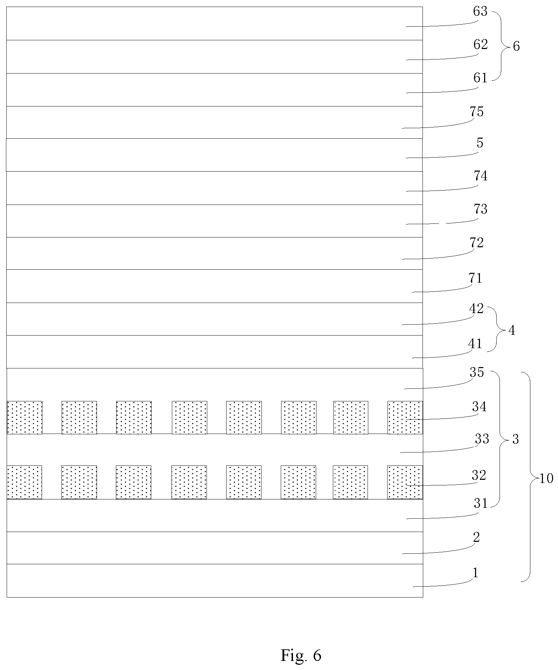

In some embodiments, as shown in Fig. 6, the forming the chip structure in step 120 further includes: forming a protective layer 75 on a side of the quantum well light emitting layer 5 away from the first semiconductor layer 4. The protective layer 75 is a nitrogen-polarity film layer. The protective layer 75 may include a u-GaN layer, and a thickness of the protective layer 75 may be 20 nm to 50 nm.

For example, the protective layer 75 is grown on the side of the quantum well light emitting layer 5 away from the first semiconductor layer 4 in a nitrogen atmosphere.

Then, as shown in Fig. 6, the second semiconductor layer 6 is formed on the side of the protective layer 75 away from the quantum well light emitting layer 5.

In some embodiments, the second semiconductor layer 6 includes an electron blocking layer 61, a hole injection layer 62, and an ohmic contact layer 63 that are sequentially formed on the side of the quantum well light emitting layer 5 away from the first semiconductor layer 4. The electron blocking layer 61, the hole injection layer 62, and the ohmic contact layer 63 are all nitrogen-polarity film layers.

The electron blocking layer 61 may include a p-AlGaN polarization-induced layer, a thickness of the p-AlGaN polarization-induced layer may be 50 nm to 60 nm, an Al component may be linearly increased from 0% to 20% or 30%, and a theoretical hole concentration of the film layer is 2×10¹⁸cm⁻³ to 2.5×10¹⁸cm⁻³. The electron blocking layer 61 may also include a p-AlₑGa₁₋ₑN/p-GaN superlattice layer, 0.15≤e≤0.25, a hole concentration may be 1.5×10¹⁸cm⁻³ to 2.5×10¹⁸cm⁻³, an Al component in p-AlₑGa₁₋ₑN is about 15% to 25%, a thickness of p-AlₑGa₁₋ₑN may be 2 nm to 3 nm, and a thickness of p-GaN may be 5 nm to 15 nm.

The hole injection layer 62 may include a p-GaN layer, and a thickness of the hole injection layer 62 may be 100 nm to 140 nm. The ohmic contact layer 63 may include a p-In_{f}Ga_{1-f}N/p-GaN superlattice layer with at least one period (for example, 2 to 4 periods), 0.1≤f≤0.2. An In component in p-In_{f}Ga_{1-f}N is about 10% to 20%, a thickness of p-In_{f}Ga_{1-f}N may be 2 nm to 3 nm, and a thickness of p-GaN may be 5 nm to 15 nm.

For example, the atmosphere is switched to the hydrogen atmosphere, and the electron blocking layer 61 is grown on the side of the protective layer 75 away from the quantum well light emitting layer 5. Then, the hole injection layer 62 is deposited on the side of the electron blocking layer 61 away from the protective layer 75. The ohmic contact layer 63 is deposited on the side of the hole injection layer 62 away from the electron blocking layer 61.

It should be noted that the second semiconductor layer 6 may also be formed by other processes, which is not specifically limited here.

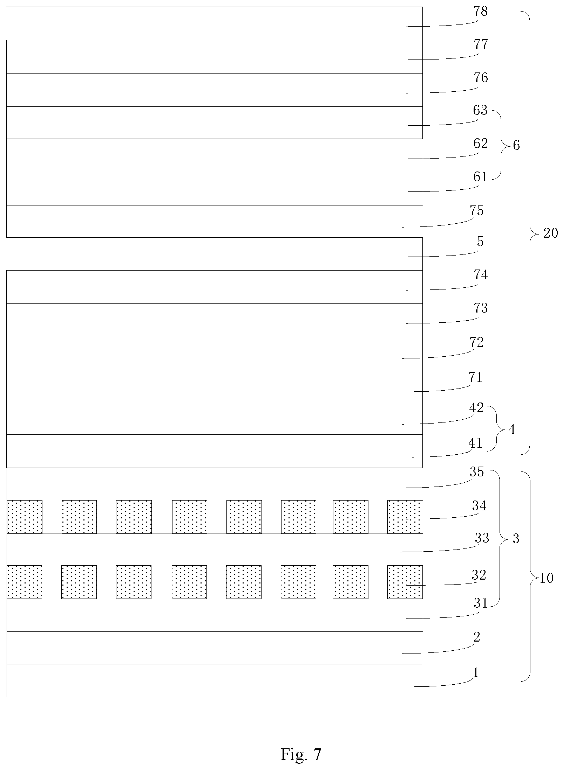

In some embodiments, as shown in Fig. 7, the forming the chip structure in step 120 further includes: sequentially forming a first transparent conductive layer 76, a first reflective layer 77, and a bonding layer 78 on a side of the second semiconductor layer 6 away from the quantum well light emitting layer 5. The first reflective layer 77 is used to enhance the light extraction efficiency of the display chip.

The first transparent conductive layer 76 may include an ITO (Indium Tin Oxide) layer. The first reflective layer 77 may include a metal reflective layer, for example, at least one of Ag and Al. The bonding layer 78 may include a metal layer, for example, at least one of Cr, Pt, Ni, Ti, Ni, and Ag.

For example, the first transparent conductive layer 76 is deposited on the side of the ohmic contact layer 63 away from the hole injection layer 62 by an electron beam evaporation or a PVD (Physical Vapor Deposition) process, and the transmittance of the first transparent conductive layer 76 is improved and the material resistance is reduced in combination with an annealing process.

Then, the first reflective layer 77 is deposited on the side of the first transparent conductive layer 76 away from the ohmic contact layer 63 by the electron beam evaporation or the PVD process. Then, the bonding layer 78 is deposited on the side of the first reflective layer 77 away from the first transparent conductive layer 76 by the electron beam evaporation or the PVD process.

It should be noted that the first transparent conductive layer 76 and the first reflective layer 77 may also be formed by other processes, which is not specifically limited here.

Along a c-axis growth direction, GaN material has two polarities, namely, gallium polarity and nitrogen polarity. Compared with the gallium polarity, the In incorporation efficiency in the nitrogen-polarity InGaN material is higher, which is mainly because In atoms in the nitrogen-polarity InGaN material may form stronger In-N bonds with surface N atoms. Moreover, there are four In-N bonds around each In atom on the surface of the nitrogen-polarity InGaN material, which makes the In desorption efficiency in the nitrogen-polarity InGaN material lower and is favorable for the In incorporation. Therefore, under a same In component, the nitrogen-polarity InGaN material may have a higher growth temperature, which is favorable for the improvement of the crystal quality of the well layer material in the quantum well and the internal quantum efficiency of the chip structure.

Moreover, the nitrogen-polarity material has a polarization direction opposite to that of the gallium-polarity material, which may reduce a barrier for carriers to be injected into the quantum well in the chip and also increase a barrier for the carriers to overflow the quantum well. Therefore, the nitrogen-polarity InGaN-based chip has higher carrier injection efficiency, and at the same time, may inhibit the carriers from overflowing, so as to relieve the Droop effect of the chip under a large current (high current density) to some extent and improve the luminous efficiency of the display chip.

In some embodiments, the manufacturing method of the display chip further includes:
bonding a base plate to a side of the chip structure away from the base.

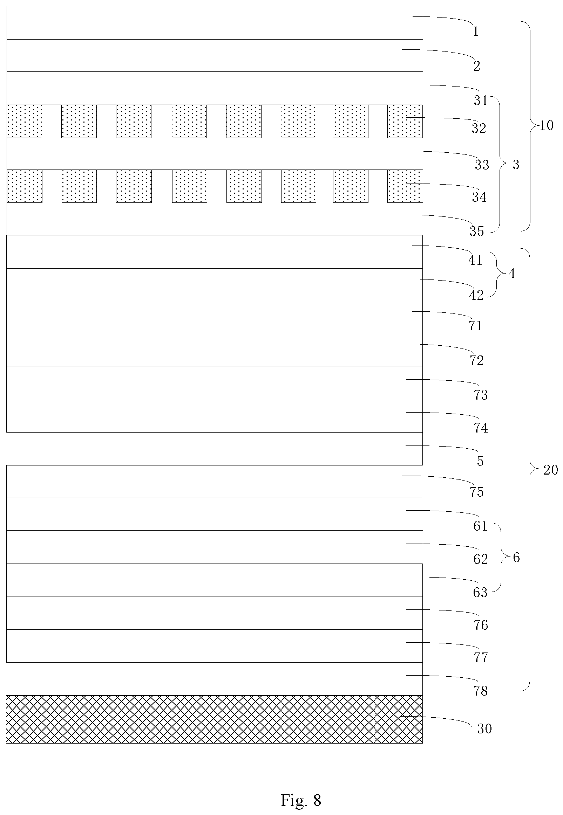

As shown in Fig. 8, the chip structure 20 is bonded to the base plate 30 through the bonding layer 78. The base plate 30 may include a silicon substrate, a silicon-based complementary metal oxide semiconductor (CMOS) pixel driving backboard, or the like.

Step 130: removing the base.

The base 10 may include the substrate 1, the buffer layer 2, and the undoped semiconductor composite layer 3. The removing the base in the display chip in step 130 includes: removing the substrate 1; and removing the buffer layer 2 and the undoped semiconductor layer composite layer 3.

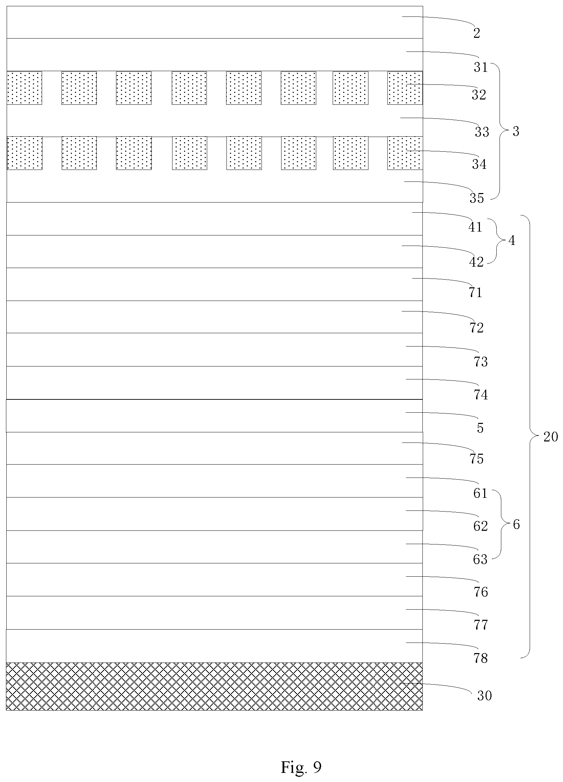

For example, as shown in Fig. 9, the substrate 1 is removed by a laser lift-off technology. A pulse laser with a wavelength of 355 nm, 266 nm, or 248 nm may be selected.

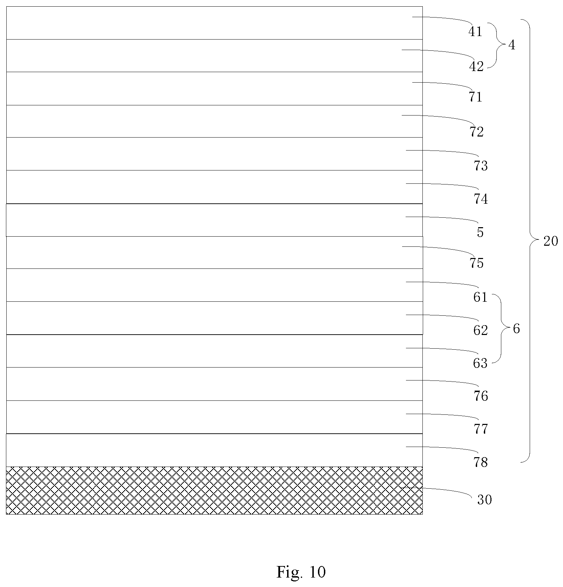

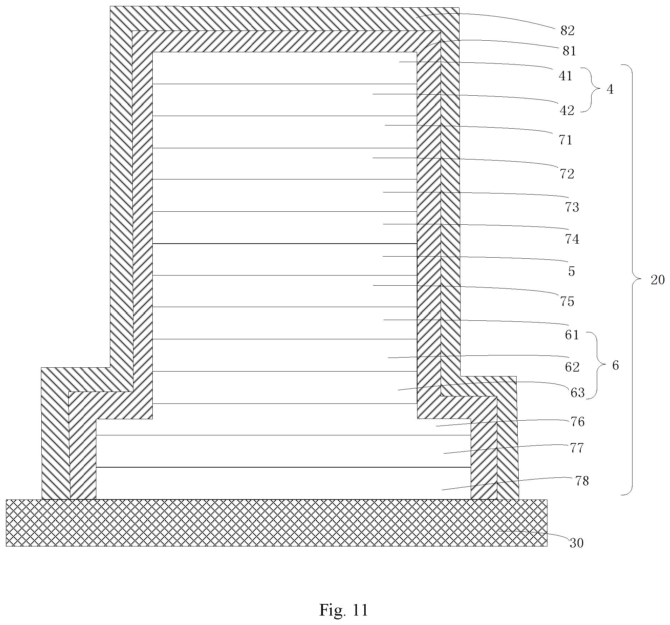

Then, as shown in Fig. 10, the buffer layer 2 and the undoped semiconductor layer composite layer 3 are etched by an ICP-RIE (Inductively Coupled Plasma-Reactive Ion Etching) process until the heavily doped semiconductor layer 41 is exposed. Then, a surface of the heavily doped semiconductor layer 41 is mechanically polished. As shown in Fig. 11, the chip structure 20 is etched by a photolithography and an ICP-RIE process, which may meet requirements of different pixel sizes.

In some embodiments, as shown in Fig. 11, the manufacturing method of the display chip further includes: forming a passivation layer 81 on a side of the chip structure 20 away from the base plate 30, the passivation layer 81 covering a side wall of the chip structure 20; and forming a second reflective layer 82 on a surface of the passivation layer 81. The passivation layer 81 is located on a side of the heavily doped semiconductor layer 41 away from the base plate 30 and the side wall of the chip structure 20, and the second reflective layer 82 is located on the surface of the passivation layer 81. The second reflective layer 82 may further enhance the light extraction efficiency of the chip.

The passivation layer 81 may include at least one of SiO₂, SiNₓ, and Al₂O₃, a thickness of the passivation layer 81 may be 10 nm to 40 nm, the second reflective layer 82 may include a DBR (Distributed Bragg Reflection) layer, and the DBR layer may include TiO₂/SiO₂ or Ta₂O₅/SiO₂.

For example, the side wall of the chip structure 20 is repaired by wet etching (such as a 25% TMAH solution), and then the passivation layer 81 is deposited by an ALD device. Then, the second reflective layer 82 is deposited by a PVD device, an electron beam evaporation device or an ALD device.

For another example, the side wall of the chip structure 20 is treated by a PE-ALD device plasma, the gas may include O₂, Ar, H₂, NH₃, N₂, etc., to deposit the passivation layer 81. Then, the second reflective layer 82 is deposited by the PVD device, the electron beam evaporation device or the ALD device.

For another example, a protective layer is deposited on the chip structure 20 by a PECVD process through a photolithography process. The thickness of the protective layer is 10 nm to 40 nm. The side wall of the chip structure 20 is treated by the PE-ALD device plasma, the gas may include O₂, Ar, H₂, NH₃, N₂, etc., to deposit the passivation layer 81. Then, the second reflective layer 82 is deposited by the PVD device, the electron beam evaporation device or the ALD device.

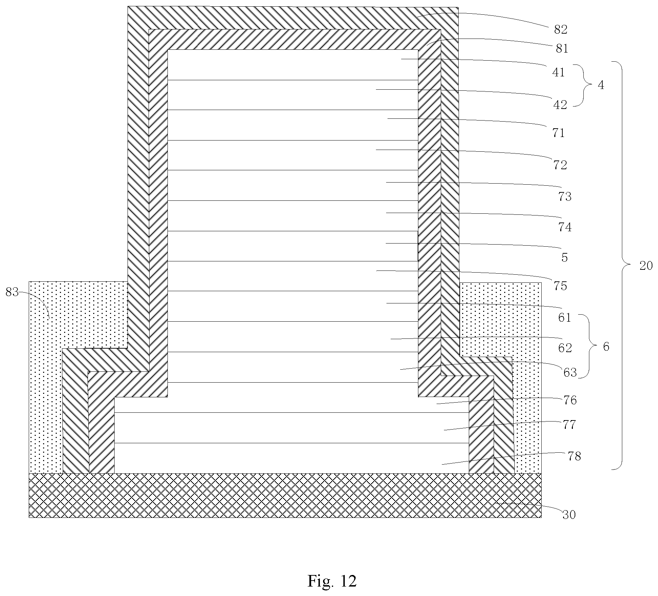

In some embodiments, as shown in Fig. 12, the manufacturing method of the display chip further includes: forming a first isolation layer 83 on a peripheral side of the chip structure 20. The first isolation layer 83 may include at least one of SiO₂ and SiNₓ.

For example, an isolation groove is etched on the peripheral side of the chip structure 20 by an ICP-RIE process. Then, the first isolation layer 83 is formed in the groove by a photolithography process and a PECVD device, the photoresist is removed by an acetone solution, and ultrasonic cleaning is performed by ethanol and deionized water and drying is performed by nitrogen.

It should be noted that the first isolation layer 83 may also be formed by other processes, which is not specifically limited here.

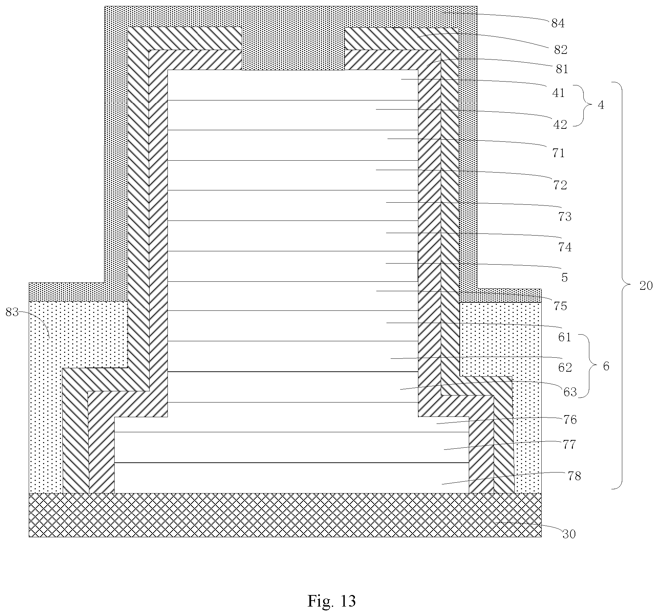

In some embodiments, as shown in Fig. 13, the manufacturing method of the display chip further includes: forming a second transparent conductive layer 84 on a side of the second reflective layer 82 away from the base plate 30, and the second transparent conductive layer 84 penetrates through the second reflective layer 82 and the passivation layer 81 and is connected to the first semiconductor layer 4. As shown in Fig. 13, the second transparent conductive layer 84 is located on the side of the second reflective layer 82 away from the base plate 30 and the side of the first isolation layer 83 away from the base plate 30, and the second transparent conductive layer 84 penetrates through the second reflective layer 82 and the passivation layer 81 and is connected to the heavily doped semiconductor layer 41 in the first semiconductor layer 4.

The second transparent conductive layer 84 may include an ITO layer, and a thickness of the second transparent conductive layer 84 may be 100 nm to 400 nm.

For example, the second reflective layer 82 and the passivation layer 81 on the side of the heavily doped semiconductor layer 41 away from the base plate 30 are etched by a photolithography process and an ICP-RIE etching process to expose the heavily doped semiconductor layer 41. The second transparent semiconductor layer 84 is deposited by an electron beam evaporation or a PVD process, and the transmittance of the second transparent semiconductor layer 84 is improved and the material resistance is reduced in combination with an annealing process.

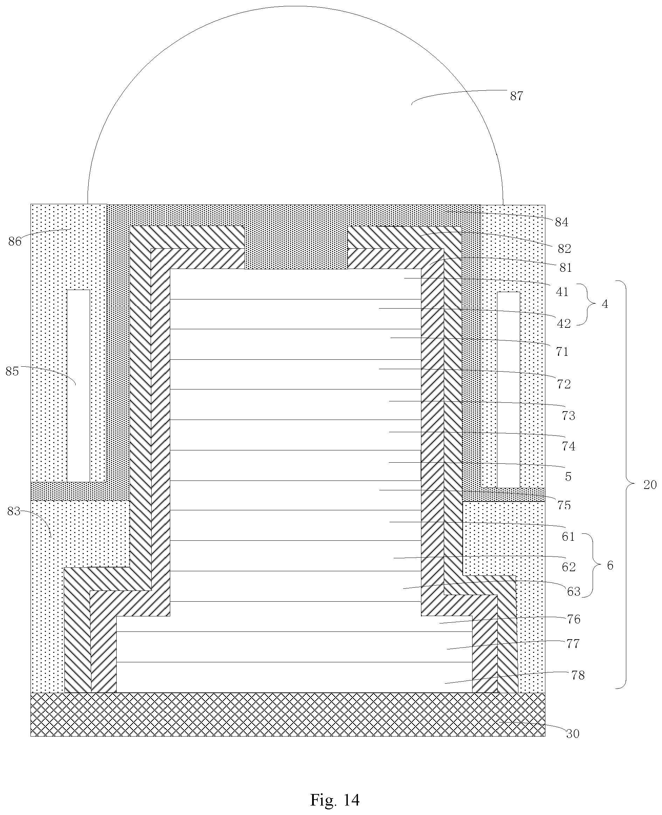

In some embodiments, as shown in Fig. 14, the manufacturing method of the display chip further includes: forming an n-type ohmic contact electrode and a third reflective layer 85 on the peripheral side of the chip structure 20, and the n-type ohmic contact electrode and the third reflective layer 85 are located on a side of the second transparent semiconductor layer 84 away from the base plate 30. The third reflective layer 85 may reduce the optical crosstalk and the light emission divergence angle between the pixels, and improve the light extraction efficiency.

The n-type ohmic contact electrode includes a metal layer, such as Ti/Al/Ti/Au. The third reflective layer may include a metal layer, for example, at least one of Ag and Al.

For example, the n-type ohmic contact electrode is prepared by a photolithography process and an electron beam evaporation. The third reflective layer is deposited by the electron beam evaporation or the PVD process. It should be noted that the n-type ohmic contact electrode and the third reflective layer 85 may also be formed by other processes, which is not specifically limited here.

In some embodiments, as shown in Fig. 14, the manufacturing method of the display chip further includes: forming a second isolation layer 86 on the peripheral side of the chip structure 20; and forming a microlens 85 on a side of the second transparent conductive layer 84 away from the base plate 30. The second isolation layer 86 covers the second transparent semiconductor layer 84, the n-type ohmic contact electrode, and the third reflective layer 85, and a surface of the second isolation layer 86 away from the base plate 30 may be flush with a surface of the second transparent conductive layer 84 away from the base plate 30. The first isolation layer 83 and the second isolation layer 86 are used to achieve electrical insulation between pixel mesas. The second isolation layer 86 may include at least one of SiO₂, SiNₓ, etc. The microlens 85 corresponds to the position of the chip structure 20, and the microlens 85 is used to increase the light collection of the chip. The microlens 85 may include SiO₂.

For example, the second isolation layer 86 is deposited by a photolithography process and a PECVD device. The microlens 87 is deposited by the PECVD device.

According to the manufacturing method of the display chip provided by the embodiments of the present application, the first semiconductor layer, the quantum well light emitting layer, and the second semiconductor layer are all nitrogen-polarity film layers, and the nitrogen-polarity film layers may be grown at a high temperature, so as to improve the crystal quality of the well layer material in the quantum well, improve the carrier injection efficiency of the chip, effectively inhibit the carriers from overflowing, relieve the Droop effect of the chip under a large current injection, and improve the luminous efficiency of the display chip, thereby improving the display effect of the display chip.

Correspondingly, embodiments of the present application further provide a display chip, which may be manufactured by the above manufacturing method of the display chip. The display chip may be a Micro-LED display chip.

As shown in Fig. 14, the display chip includes the chip structure 20, the chip structure 20 includes the first semiconductor layer 4, the quantum well light emitting layer 5, and the second semiconductor layer 6, the quantum well light emitting layer 5 is located on one side of the first semiconductor layer 4, and the second semiconductor layer 6 is located on a side of the quantum well light emitting layer 5 away from the first semiconductor layer 4.

One of the first semiconductor layer 4 and the second semiconductor layer 6 is an n-type semiconductor layer, and the other one is a p-type semiconductor layer, that is, the first semiconductor layer 4 is an n-type semiconductor layer, and the second semiconductor layer 6 is a p-type semiconductor layer; or, the first semiconductor layer 4 is a p-type semiconductor layer, and the second semiconductor layer 6 is an n-type semiconductor layer.

The first semiconductor layer 4, the quantum well light emitting layer 5, and the second semiconductor layer 6 are all nitrogen-polarity film layers.

In this embodiment, the first semiconductor layer 4, the quantum well light emitting layer 5, and the second semiconductor layer 6 are all nitrogen-polarity film layers, and the nitrogen-polarity film layers may be grown at a high temperature, so as to improve the crystal quality of the well layer material in the quantum well, improve the carrier injection efficiency of the chip, effectively inhibit the carriers from overflowing, relieve the Droop effect of the chip under a large current injection, and improve the luminous efficiency of the display chip.

In some embodiments, the chip structure 20 is a nitrogen-polarity InGaN-based chip structure, the first semiconductor layer 4 is an n-type semiconductor layer, and the second semiconductor layer 6 is a p-type semiconductor layer.

In some embodiments, as shown in Fig. 14, the first semiconductor layer includes the heavily doped semiconductor layer 41 and the lightly doped semiconductor layer 42. The lightly doped semiconductor layer 42 is located between the heavily doped semiconductor layer 41 and the quantum well light emitting layer 5. The heavily doped semiconductor layer 41 and the lightly doped semiconductor layer 42 are both nitrogen-polarity film layers.

The heavily doped semiconductor layer 41 may include an n-GaN heavily doped layer, an electron concentration of the heavily doped semiconductor layer 41 is 1×10¹⁸cm⁻³ to 2×10¹⁹cm⁻³, and a thickness of the heavily doped semiconductor layer 41 is 0.5 µm to 1.5 µm. The heavily doped semiconductor layer 41 may also include an n-Al_{c}Ga_{1-c}N/n-GaN superlattice layer, 0.02≤c≤0.15, and an electron concentration is 1×10¹⁸cm⁻³ to 2×10¹⁹cm⁻³. An Al component in n-Al_{c}Ga_{1-c}N is about 2% to 15%, a thickness may be 2 nm to 3 nm, and a thickness of n-GaN may be 2.5 nm to 15 nm. The n-Al_{c}Ga_{1-c}N/n-GaN superlattice layer may relieve the extension of dislocations and stress regulation.

The lightly doped semiconductor layer 42 may include an n-GaN lightly doped layer, an electron concentration of the lightly doped semiconductor layer 42 is 1×10¹⁷cm⁻³ to 5×10¹⁷cm⁻³, and a thickness of the lightly doped semiconductor layer 42 is 0.2 µm to 0.5 µm. The lightly doped semiconductor layer 42 may also include an n-Al_{g}Ga_{1-g}N/n-GaN superlattice layer, 0.02≤g≤0.08, and an electron concentration is 1×10¹⁷cm⁻³ to 5×10¹⁷cm⁻³. An Al component in n-Al_{g}Ga_{1-g}N is about 2% to 8%, a thickness is 2 nm to 3 nm, and a thickness of n-GaN is 2.5 nm to 15 nm.

In some embodiments, as shown in Fig. 14, the chip structure 20 further includes the fourth undoped semiconductor layer 71, the first barrier layer 72, the first superlattice layer 73, and the second superlattice layer 74 that are arranged in sequence between the first semiconductor layer 4 and the quantum well light emitting layer 5, that is, the fourth undoped semiconductor layer 71 is located between the lightly doped semiconductor layer 42 and the quantum well light emitting layer 5, the first barrier layer 72 is located between the fourth undoped semiconductor layer 71 and the quantum well light emitting layer 5, the first superlattice layer 73 is located between the first barrier layer 72 and the quantum well light emitting layer 5, and the second superlattice layer 74 is located between the first superlattice layer 73 and the quantum well light emitting layer 5. The fourth undoped semiconductor layer 71, the first barrier layer 72, the first superlattice layer 73, and the second superlattice layer 74 are all nitrogen-polarity film layers.

The fourth undoped semiconductor layer 71 may include a u-GaN layer, and a thickness of the fourth undoped semiconductor layer 71 may be 10 nm to 30 nm. The first barrier layer 72 may include a GaN layer, and a thickness of the first barrier layer 72 may be 10 nm to 30 nm. The first superlattice layer 73 may include a u-InₐGa₁₋ₐN/u-GaN superlattice layer with at least one period (for example, 1 to 3 periods), 0.01≤a≤0.05. A thickness of u-InₐGa₁₋ₐN may be 2 nm to 3 nm, an In component may be 1% to 5%, and a thickness of u-GaN may be 2.5 nm to 15 nm. The second superlattice layer 74 may include a u-In_{b}Ga_{1-b}N/n-GaN superlattice layer with at least one period (for example, 1 to 3 periods), 0.05≤b≤0.1. An electron concentration of n-GaN may be 1×10¹⁷cm⁻³ to 5×10¹⁷cm⁻³, a thickness of u-In_{b}Ga_{1-b}N may be 2 nm to 3 nm, an In component may be 5% to 10%, and a thickness of n-GaN may be 2.5 nm to 15 nm.

In some embodiments, the quantum well light emitting layer 5 includes a red light quantum well light emitting layer.

In some embodiments, the quantum well light emitting layer 5 includes at least one periodic structure (for example, 2 to 3 periodic structures), each periodic structure including a fifth undoped semiconductor layer, a first well layer, a first cap layer, a second barrier layer, a sixth undoped semiconductor layer, a second well layer, a second cap layer, and a third barrier layer that are arranged in sequence between the first semiconductor layer 4 and the second semiconductor layer 6. The fifth undoped semiconductor layer, the first well layer, the first cap layer, the second barrier layer, the sixth undoped semiconductor layer, the second well layer, the second cap layer, and the third barrier layer are all nitrogen-polarity film layers.

The fifth undoped semiconductor layer may include a low-temperature u-GaN layer, and a thickness of the fifth undoped semiconductor layer may be 2 nm to 3 nm. The first well layer may include a u-InₓGa₁₋ₓN layer, 0.1≤x≤0.15, and a thickness of the first well layer may be 2.5 nm to 3.5 nm. The first cap layer may include a GaN layer, and a thickness of the first cap layer may be 2 nm to 3 nm. The second barrier layer may include a GaN layer or a u-In_{y}Ga_{1-y}N layer, 0.01≤y≤0.03, and a thickness of the second barrier layer may be 10 nm to 15 nm. The sixth undoped semiconductor layer may include a low-temperature u-GaN layer, and a thickness of the sixth undoped semiconductor layer may be 2 nm to 3 nm. The second well layer may include a u-In_{z}Ga_{1-z}N layer, 0.35≤z≤0.4, and a thickness of the second well layer may be 2.5 nm to 3.5 nm. The second cap layer may include a GaN layer, and a thickness of the second cap layer may be 2 nm to 3 nm. The third barrier layer may include a u-Al_{d}Ga_{1-d}N layer, 0.3≤d≤0.35, and a thickness of the third barrier layer may be 10 nm to 15 nm.

In this embodiment, the nitrogen-polarity film layer is used, so that the quantum well light emitting layer may be grown at a high temperature, the crystal quality of the barrier layer material in the quantum well light emitting layer is improved, the barrier for carriers to be injected into the quantum well light emitting layer in the chip may be reduced, and the barrier for the carriers to overflow the quantum well light emitting layer may also be improved, that is, the carrier injection efficiency is improved, and at the same time, the carriers overflowing is suppressed, and the Droop effect of the chip under a large current injection is relieved.

In some embodiments, as shown in Fig. 14, the chip structure 20 may further include a protective layer 75, the protective layer 75 being located between the quantum well light emitting layer 5 and the second semiconductor layer 6. The protective layer 75 is a nitrogen-polarity film layer. The protective layer 75 includes a u-GaN layer, and a thickness of the protective layer 75 is 20 nm to 50 nm.

In some embodiments, as shown in Fig. 14, the second semiconductor layer 6 includes an electron blocking layer 61, a hole injection layer 62, and an ohmic contact layer 63 that are arranged in sequence on a side of the quantum well light emitting layer 5 away from the first semiconductor layer 4. The electron blocking layer 61, the hole injection layer 62, and the ohmic contact layer 63 are all nitrogen-polarity film layers.

The electron blocking layer 61 may include a p-AlGaN polarization-induced layer, a thickness of the p-AlGaN polarization-induced layer may be 50 nm to 60 nm, an Al component may be linearly increased from 0% to 20% or 30%, and a theoretical hole concentration of the film layer is 2×10¹⁸cm⁻³ to 2.5×10¹⁸cm⁻³. The electron blocking layer 61 may also include a p-AlₑGa₁₋ₑN/p-GaN superlattice layer, 0.15≤e≤0.25, a hole concentration may be 1.5×10¹⁸cm⁻³ to 2.5×10¹⁸cm⁻³, an Al component in p-AlₑGa₁₋ₑN is about 15% to 25%, a thickness of p-AlₑGa₁₋ₑN may be 2 nm to 3 nm, and a thickness of p-GaN may be 5 nm to 15 nm.

The hole injection layer 62 may include a p-GaN layer, and a thickness of the hole injection layer 62 may be 100 nm to 140 nm. The ohmic contact layer 63 may include a p-In_{f}Ga_{1-f}N/p-GaN superlattice layer with at least one period (for example, 2 to 4 periods), 0.1≤f≤0.2. An In component in p-In_{f}Ga_{1-f}N is about 10% to 20%, a thickness of p-In_{f}Ga_{1-f}N may be 2 nm to 3 nm, and a thickness of p-GaN may be 5 nm to 15 nm.

In some embodiments, the chip structure 20 further includes a first transparent conductive layer 76, a first reflective layer 77, and a bonding layer 78 that are sequentially located on a side of the second semiconductor layer 6 away from the quantum well light emitting layer 5, that is, the first transparent conductive layer 76 is located on a side of the ohmic contact layer 63 away from the hole injection layer 62, the first reflective layer 77 is located on a side of the first transparent conductive layer 76 away from the ohmic contact layer 63, and the bonding layer 78 is located on a side of the first reflective layer 77 away from the first transparent conductive layer 76. The first reflective layer 77 is used to enhance the light extraction efficiency of the display chip, and the bonding layer 78 is used to bond the display chip to other base plates.

The first transparent conductive layer 76 may include an ITO (Indium Tin Oxide) layer. The first reflective layer 77 may include a metal reflective layer, for example, at least one of Ag and Al. The bonding layer 78 may include a metal layer, for example, at least one of Cr, Pt, Ni, Ti, Ni, and Ag.

Along a c-axis growth direction, GaN material has two polarities, namely, gallium polarity and nitrogen polarity. Compared with the gallium polarity, the In incorporation efficiency in the nitrogen-polarity InGaN material is higher, which is mainly because In atoms in the nitrogen-polarity InGaN material may form stronger In-N bonds with surface N atoms. Moreover, there are four In-N bonds around each In atom on the surface of the nitrogen-polarity InGaN material, which makes the In desorption efficiency in the nitrogen-polarity InGaN material lower and is favorable for the In incorporation. Therefore, under a same In component, the nitrogen-polarity InGaN material may have a higher growth temperature, which is favorable for the improvement of the crystal quality of the well layer material in the quantum well and the internal quantum efficiency of the chip structure.

Moreover, the nitrogen-polarity material has a polarization direction opposite to that of the gallium-polarity material, which may reduce a barrier for carriers to be injected into the quantum well in the chip and also increase a barrier for the carriers to overflow the quantum well. Therefore, the nitrogen-polarity InGaN-based chip structure has higher carrier injection efficiency, and at the same time, may inhibit the carriers from overflowing, so as to relieve the Droop effect of the chip under a large current (high current density) to some extent and improve the luminous efficiency of the display chip.

In some embodiments, as shown in Fig. 14, the display chip further includes a base plate 30. The base plate 30 is bonded to a side of the chip structure 20 away from the first semiconductor layer 4.

In some embodiments, the base plate 30 is located on a side of the bonding layer 78 away from the first semiconductor layer 4, and the base plate 30 is bonded to the chip structure 20 through the bonding layer 78.

The base plate 30 may include a silicon substrate or a silicon-based complementary metal oxide semiconductor (CMOS) pixel driving backboard.

In some embodiments, as shown in Fig. 14, the display chip further includes the passivation layer 81 and the second reflective layer 82. The passivation layer 81 is located on a side of the chip structure 20 away from the base plate 30 and covers the side wall of the chip structure 20, that is, the passivation layer 81 is located on a side of the heavily doped semiconductor layer 41 away from the base plate 30 and the side wall of the chip structure 20. The second reflective layer 82 covers the passivation layer 81, that is, the second reflective layer 82 is located on the surface of the passivation layer 81.

The passivation layer 81 may include at least one of SiO₂, SiNₓ, and Al₂O₃, the thickness of the passivation layer 81 may be 10 nm to 40 nm, the second reflective layer 82 may include the DBR layer, and the DBR layer may include TiO₂/SiO₂ or Ta₂O₅/SiO₂.

In some embodiments, the display chip further includes the first isolation layer 83, the first isolation layer 83 being located on the peripheral side of the chip structure 20. The first isolation layer 83 may include at least one of SiO₂ and SiNₓ.

In some embodiments, the display chip further includes the second transparent conductive layer 84, the second transparent conductive layer 84 being located on a side of the second reflective layer 82 away from the base plate 30 and a side of the first isolation layer 83 away from the base plate 30, and the second transparent conductive layer 84 penetrating through the second reflective layer 82 and the passivation layer 81 and being connected to the heavily doped semiconductor layer 41 in the first semiconductor layer 4.

The second transparent conductive layer 84 may include an ITO layer, and the thickness of the second transparent conductive layer 84 may be 100 nm to 400 nm.

In some embodiments, the display chip further includes the n-type ohmic contact electrode, the n-type ohmic contact electrode being located on the peripheral side of the chip structure 20, and the n-type ohmic contact electrode being located on a side of the second transparent conductive layer 84 away from the base plate 30. The n-type ohmic contact electrode includes a metal layer, such as Ti/Al/Ti/Au.

In some embodiments, as shown in Fig. 14, the display chip further includes the third reflective layer 85, the third reflective layer 85 being located on the peripheral side of the chip structure 20, and the third reflective layer 85 being located on the side of the second transparent conductive layer 84 away from the base plate 30. The third reflective layer 85 may reduce the optical crosstalk and the light emission divergence angle between the pixels, and improve the light extraction efficiency of the chip. The third reflective layer 85 may include a metal layer, for example, at least one of Ag and Al.

In some embodiments, the display chip further includes the second isolation layer 86, the second isolation layer 86 being located on the peripheral side of the chip structure 20 and covering the second transparent conductive layer 84 and the third reflective layer 85. The surface of the second isolation layer 86 away from the base plate 30 may be flush with the surface of the second transparent conductive layer 84 away from the base plate 30. The second isolation layer 86 may include at least one of SiO₂, SiNₓ, etc. The first isolation layer 83 and the second isolation layer 86 are used to achieve electrical insulation between the pixel mesas.

In some embodiments, the display chip further includes the microlens 85, the microlens 85 being located on a side of the second transparent conductive layer 84 away from the chip structure 20, and the microlens 85 corresponding to the position of the chip structure 20. The microlens 85 is used to increase the light collection of the chip. The microlens 85 includes SiO₂.

According to the display chip provided by embodiments of the present application, the first semiconductor layer 4, the quantum well light emitting layer 5, and the second semiconductor layer 6 are all nitrogen-polarity film layers, and the nitrogen-polarity film layers may be grown at a high temperature, so as to improve the crystal quality of the well layer material in the quantum well, improve the carrier injection efficiency of the chip, effectively inhibit the carriers from overflowing, relieve the Droop effect of the chip under a large current injection, and improve the luminous efficiency of the display chip, thereby improving the display effect of the display chip.

The terms "first", "second", etc. in the specification and claims of the present application are used to distinguish similar objects, and are not used to describe a specific order or sequence. It should be understood that the data used in this way may be interchanged under appropriate circumstances, so that the embodiments of the present application may be implemented in orders other than those illustrated or described herein, and the objects distinguished by "first", "second", etc. are usually of one type, and the number of objects is not limited, for example, the first object may be one or more.

In the description of the present application, "a plurality of" means two or more.

In the description of this specification, descriptions with reference to the terms "one embodiment", "some embodiments", "schematic embodiments", "example", "specific example", or "some examples" mean that specific features, structures, materials, or characteristics described in conjunction with the embodiment or example are included in at least one embodiment or example of the present application. In this specification, the schematic expressions of the above terms do not necessarily refer to the same embodiment or example. Moreover, the specific features, structures, materials or characteristics described may be combined in any one or more embodiments or examples in any suitable way.

Although the embodiments of the present application have been shown and described, those of ordinary skill in the art may understand that various changes, modifications, substitutions, and variations may be made to these embodiments without departing from the principles and spirit of the present application. The scope of the present application is defined by the claims and equivalents thereof.

## Claims

1. A display chip, comprising:
a chip structure, comprising a first semiconductor layer, a quantum well light emitting layer, and a second semiconductor layer that are arranged in sequence, wherein one of the first semiconductor layer and the second semiconductor layer is an n-type semiconductor layer, and the other one is a p-type semiconductor layer;
wherein the first semiconductor layer, the quantum well light emitting layer, and the second semiconductor layer are all nitrogen-polarity film layers.

2. The display chip of claim 1, wherein the chip structure further comprises a fourth undoped semiconductor layer, a first barrier layer, a first superlattice layer, and a second superlattice layer that are arranged in sequence between the first semiconductor layer and the quantum well light emitting layer; and
the fourth undoped semiconductor layer, the first barrier layer, the first superlattice layer, and the second superlattice layer are all nitrogen-polarity film layers.

3. The display chip of claim 1 or 2, wherein the first semiconductor layer comprises a heavily doped semiconductor layer and a lightly doped semiconductor layer located between the heavily doped semiconductor layer and the quantum well light emitting layer; and
the heavily doped semiconductor layer and the lightly doped semiconductor layer are both nitrogen-polarity film layers.

4. The display chip of any of claims 1 to 3, wherein the quantum well light emitting layer comprises a fifth undoped semiconductor layer, a first well layer, a first cap layer, a second barrier layer, a sixth undoped semiconductor layer, a second well layer, a second cap layer, and a third barrier layer that are arranged in sequence between the first semiconductor layer and the second semiconductor layer; and
the fifth undoped semiconductor layer, the first well layer, the first cap layer, the second barrier layer, the sixth undoped semiconductor layer, the second well layer, the second cap layer, and the third barrier layer are all nitrogen-polarity film layers.

5. The display chip of any of claims 1 to 4, wherein the second semiconductor layer comprises an electron blocking layer, a hole injection layer, and an ohmic contact layer that are arranged in sequence on a side of the quantum well light emitting layer away from the first semiconductor layer; and
the electron blocking layer, the hole injection layer, and the ohmic contact layer are all nitrogen-polarity film layers.

6. The display chip of any of claims 1 to 5, wherein the chip structure further comprises a first transparent conductive layer, a first reflective layer, and a bonding layer that are sequentially located on a side of the second semiconductor layer away from the quantum well light emitting layer.

7. The display chip of any of claims 1 to 6, wherein the chip structure further comprises a protective layer located between the quantum well light emitting layer and the second semiconductor layer.

8. The display chip of any of claims 1 to 7, wherein the display chip further comprises a base plate; and
the base plate is bonded to a side of the chip structure away from the first semiconductor layer.

9. The display chip of claim 8, wherein the display chip further comprises a passivation layer and a second reflective layer; and
the passivation layer is located on a side of the chip structure away from the base plate and covers a side wall of the chip structure, and the second reflective layer covers the passivation layer.

10. The display chip of claim 9, wherein the display chip further comprises a second transparent conductive layer located on a side of the second reflective layer away from the base plate, and the second transparent conductive layer penetrates through the second reflective layer and the passivation layer and is connected to the first semiconductor layer.

11. The display chip of claim 10, wherein the display chip further comprises a third reflective layer located on a peripheral side of the chip structure, and a microlens located on a side of the second transparent conductive layer away from the chip structure.

12. The display chip of any of claims 1 to 11, wherein the quantum well light emitting layer comprises a red light quantum well light emitting layer.

13. A manufacturing method of a display chip, comprising:
forming a base;
forming a chip structure on one side of the base, the chip structure comprising a first semiconductor layer, a quantum well light emitting layer, and a second semiconductor layer that are arranged in sequence on the one side of the base, wherein one of the first semiconductor layer and the second semiconductor layer is an n-type semiconductor layer, and the other one is a p-type semiconductor layer, wherein the first semiconductor layer, the quantum well light emitting layer, and the second semiconductor layer are all nitrogen-polarity film layers; and
removing the base.

14. The manufacturing method of a display chip of claim 13, wherein the base comprises a substrate, a buffer layer, and an undoped semiconductor composite layer;
the forming the base comprises:
providing the substrate;
forming the buffer layer on one side of the substrate; and
forming the undoped semiconductor composite layer on a side of the buffer layer away from the substrate, the chip structure being located on a side of the undoped semiconductor composite layer away from the buffer layer; and
wherein the buffer layer and the undoped semiconductor composite layer are both nitrogen-polarity film layers.

15. The manufacturing method of a display chip of claim 14, wherein the undoped semiconductor composite layer comprises a plurality of undoped semiconductor layers and at least one insertion layer that are arranged in a stacked manner, and there is one insertion layer between any two adjacent undoped semiconductor layers; and
the undoped semiconductor layers and the insertion layer are all nitrogen-polarity film layers.

16. The manufacturing method of a display chip of claim 15, wherein the plurality of undoped semiconductor layers comprise a first undoped semiconductor layer, a second undoped semiconductor layer, and a third undoped semiconductor layer, and the at least one insertion layer comprises a first insertion layer and a second insertion layer; the first undoped semiconductor layer, the first insertion layer, the second undoped semiconductor layer, the second insertion layer, and the third undoped semiconductor layer are arranged in sequence between the buffer layer and the first semiconductor layer; and
the first undoped semiconductor layer, the second undoped semiconductor layer, and the third undoped semiconductor layer each comprise a u-GaN layer, the first insertion layer comprises a porous SiNx layer, and the second insertion layer comprises an AlN layer.

17. The manufacturing method of a display chip of any of claims 14 to 16, wherein the removing the base comprises:
removing the substrate; and
removing the buffer layer and the undoped semiconductor composite layer.

18. The manufacturing method of a display chip of any of claims 13 to 17, wherein before the removing the base, the method further comprises:
bonding a side of the chip structure away from the base to a base plate.

19. The manufacturing method of a display chip of claim 18, wherein after the removing the base, the method further comprises:
forming a passivation layer on a side of the chip structure away from the base plate, and the passivation layer covers a side wall of the chip structure; and
forming a second reflective layer on a surface of the passivation layer.

20. The manufacturing method of a display chip of claim 19, wherein the method further comprises:
forming a second transparent conductive layer on a side of the second reflective layer away from the base plate, and the second transparent conductive layer penetrates through the second reflective layer and the passivation layer and is connected to the first semiconductor layer; and
forming a microlens on a side of the second transparent conductive layer away from the base plate.
